# EUROPÄISCHE PATENTSCHRIFT

(11) **EP 0 799 514 B1**
(45) Veröffentlichungstag und Bekanntmachung des Hinweises auf die Patenterteilung: **26.08.1998**
(21) Anmeldenummer: 95936958.8
(22) Anmeldetag: 23.11.1995
(51) Int. Cl.: H02H 7/085, H02H 7/093

(54) **SCHALTUNGSANORDNUNG ZUM DETEKTIEREN EINES ÜBERLASTZUSTANDS IN EINEM VERSTELLANTRIEB**
CIRCUIT FOR DETECTING OVERLOAD IN AN ADJUSTING DRIVE
CIRCUITERIE PERMETTANT DE DETECTER UN ETAT DE SURCHARGE DANS UN MECANISME DE COMMANDE DE REGLAGE

(30) Priorität: 19.12.1994 DE 4445106
(43) Veröffentlichungstag der Anmeldung: 08.10.1997
(73) Patentinhaber: ROBERT BOSCH GMBH, 70442 Stuttgart (DE)
(72) Erfinder: LOCHMAHR, Gunnar, D-71229 Leonberg (DE); PETER, Cornelius, D-77815 Bühl (DE); KNECHT, Gerhard, D-76473 Iffezheim (DE)
(86) Internationale Anmeldenummer: DE9501639
(87) Internationale Veröffentlichungsnummer: WO9619857

(56) Entgegenhaltungen:
- GB-A- 2 264 825
- US-A- 4 275 342
- US-A- 5 334 876

## Beschreibung

### Stand der Technik

Die Erfindung geht aus von einer Schaltungsanordnung zum Detektieren eines Überlastzustands in einem von einem Elektromotor angetriebenen Verstellantrieb nach der Gattung des Hauptanspruchs. Aus der DE-Patentschrift 28 20 330 ist eine Schaltungsanordnung bekannt, die sowohl den statischen, durch einen Elektromotor eines Verstellantriebs fließenden Motorstrom als auch die zeitlichen Änderungen des Motorstroms berücksichtigt bei der Ermittlung eines Überlastsignals. Der Motorstrom ist eine Kenngröße des Verstellantriebs, die ein Maß für eine im Verstellantrieb auftretende Kraft angibt. Die vorbekannte Schaltungsanordnung findet beispielsweise Anwendung bei einem in einem Kraftfahrzeug angeordneten elektrischen Fensterheberantrieb, bei dem die Verstellkraft oder das zum Verstellen benötigte Drehmoment einerseits für einen zuverlässigen Betrieb des Fensterheberantriebs ausgelegt sein müssen und andererseits wegen der Verletzungsgefahr von Personen zu begrenzen sind.

In der Druckschrift US-A-5,334,876 ist eine Schaltungsvorrichtung zur Detektierung eines Überlastzustandes eines Elektromotors offenbart. Die Detektierung erfolgt durch den Vergleich einer Kenngröße des Motorstroms mit einem Grenzwert. Darüber hinaus wird die Drehzahl des Elektromotors zur Bestimmung der Geschwindigkeit, der Bewegungsrichtung und der Position eines Fensters oder Schiebedachs ausgewertet.

Ferner ist aus der GB-A-2,264,825 eine Schaltungsanordnung zum Detektieren eines Überlastzustandes in einem von einem Elektromotor betriebenen Verstellantrieb bekannt, die den Überlastzustand durch Überwachung der Rotationsgeschwindigkeit des Motors ermittelt. Die Schaltungsanordnung gibt ein Signal ab, das den Zustand des Motors charakterisiert (Normal- bzw. Überlastzustand).

Bei den heute zum Einsatz gelangenden Elektromotoren für Verstellantriebe, die aus Kostengründen bis an die Grenze ihrer Leistungsfähigkeit ausgenutzt werden, können normale Betriebssituationen auftreten, die einen hohen Motorstrom erfordern, der in den vorbekannten Anordnungen zu einem unnötigen Auslösen des Überlastsignals führen würde.

Der Erfindung liegt die Aufgabe zugrunde, eine Schaltungsanordnung anzugeben, die einen Überlastzustand in einem von einem Elektromotor angetriebenen Verstellantrieb zuverlässig detektiert.

Die Aufgabe wird durch die im Hauptanspruch angegebenen Merkmale gelöst.

### Vorteile der Erfindung

Die erfindungsgemäße Schaltungsanordnung weist den Vorteil auf, daß ein hoher Grenzwert vorgegeben werden kann für eine Kenngröße, die aus dem Motorstrom abgeleitet ist. Der hohe Kenngrößengrenzwert ermöglicht dem Verstellantrieb eine rasche Veränderung der Position eines mit dem Verstellantrieb zu verstellenden Teils, ohne daß ein Überlastsignal ausgegeben wird, das beispielsweise den Elektromotor stillsetzt oder dessen Antriebsrichtung reversiert. Erfindungsgemäß ist die Einbeziehung der Drehzahl des Verstellantriebs vorgesehen. Das von einer Drehzahlermittlung bereitgestellte Maß für eine innerhalb des Verstellantriebs auftretende Drehzahl wird in einem Komparator mit einem vorgegebenen Drehzahlgrenzwert verglichen. Eine Grenzwertüberschreitung löst ein Freigabesignal aus. Ein vorhandenes Schaltsignal, das gegebenenfalls bei dem Vergleich der aus dem Motorstrom ermittelten Kenngröße mit dem Kenngrößengrenzwert aufgetreten ist, wird in einer Freigabe durch das Freigabesignal als Überlastsignal weitergegeben. Eine Überschreitung des Kenngrößengrenzwerts durch die aus dem Motorstrom abgeleitete Kenngröße führt demnach nur dann zur Auslösung des Überlastsignals, wenn gleichzeitig die innerhalb des Verstellantriebs auftretende Drehzahl auf einen Wert unterhalb des Drehzahlgrenzwerts absinkt.

Die erfindungsgemäße Schaltungsanordnung verhindert zuverlässig eine thermische Überlastung des Elektromotors, die insbesondere bei hohen Motorströmen und einer geringen Motordrehzahl auftreten kann, bei der eine ausreichende Kühlung durch die Drehbewegung des Ankers nicht mehr gewährleistet ist. Insbesondere ermöglicht die erfindungsgemäße Schaltungsanordnung das Erkennen eines sich abzeichnenden Blockierzustands des Elektromotors, der sich durch ein starkes Absinken des Drehzahlniveaus ankündigt.

Das Überlastsignal kann zu einem Abschalten des Elektromotors verwendet werden. Gleichermaßen kann das Überlastsignal ein Reversieren des Elektromotors veranlassen, wobei eine Unterscheidung zwischen einem Abschalten und einem Reversieren vorzugsweise in Abhängigkeit von der Position festgelegt wird, die das vom Verstellantrieb zu verstellende Teil einnimmt.

Vorteilhafte Weiterbildungen und Ausgestaltungen der erfindungsgemäßen Schaltungsanordnung ergeben sich aus abhängigen Ansprüchen.

Als Kenngröße des Motorstroms ist vorzugsweise die absolute Höhe des Motorstroms vorgesehen. Als Kenngröße des Motorstroms sind weiterhin sowohl dessen auf die Zeit als auch auf die Position bezogene Änderungen verwendbar. Die zeitbezogenen Änderungen werden in einem Differenzierer ermittelt, während die ortsbezogenen Änderungen vorzugsweise als Differenzen ermittelt werden, die bei Positionsänderungen um vorgegebene Werte aufgetreten sind. Eine weitere vorteilhafte Maßnahme sieht vor, daß bei der Ermittlung der Kenngröße sowohl die absolute Höhe des Motorstroms und/oder die zeitlichen und/oder die ortsbezogenen Änderungen berücksichtigt werden.

Eine vorteilhafte Ausgestaltung sieht die Ermittlung einer im Verstellantrieb auftretenden Drehzahl aus der Welligkeit des Motorstroms vor. Die Maßnahme weist gegenüber der ebenfalls möglichen Erfassung der Drehzahl mittels separater Sensoren, beispielsweise mit Hallsensoren, den Vorteil einer preisgünstigen Realisierung auf, da der Motorstrom zum Ermitteln der aus dem Motorstrom abgeleiteten Kenngröße ohnehin zu erfassen ist.

Sofern in der Ansteuerung des Elektromotors zumindest ein Halbleiter-Leistungsbauelement vorhanden ist, durch das der Motorstrom fließt, wird der Motorstrom vorzugsweise über den an diesem Halbleiter-Leistungsbauelement auftretenden Spannungsabfall ermittelt.

Eine andere Ausgestaltung sieht vor, daß zumindest einer der beiden vorzugebenden Grenzwerte abhängig ist von der Position des von dem Verstellantrieb zu verstellenden Teils. Mit dieser Maßnahme wird das Detektieren des Überlastzustands an die Gegebenheiten des Verstellantriebs angepaßt. Die Position des vom Verstellantrieb zu verstellenden Teil wird vorzugsweise, ebenso wie die Drehzahl, über die Welligkeit des Motorstroms ermittelt. Die Welligkeit des Motorstroms kann zur Steuerung eines Vorwärts-Rückwärtszählers herangezogen werden, dessen Ausgangssignal ein Maß für die Position des zu verstellenden Teils ist.

Die erfindungsgemäße Schaltungsanordnung eignet sich zur Verwendung in Verstellantrieben, die vorzugsweise in einem Kraftfahrzeug angeordnet sind. Bei dieser Anwendung werden die Elektromotoren heute bis zur Grenze der Belastbarkeit ausgenutzt. Die Zuverlässigkeit bei der Erkennung eines Überlastzustands ist deshalb bei dieser Verwendung besonders wesentlich.

Weitere vorteilhafte Weiterbildungen und Ausgestaltungen der erfindungsgemäßen Schaltungsanordnung ergeben sich aus weiteren abhängigen Ansprüchen und aus der folgenden Beschreibung.

### Zeichnung

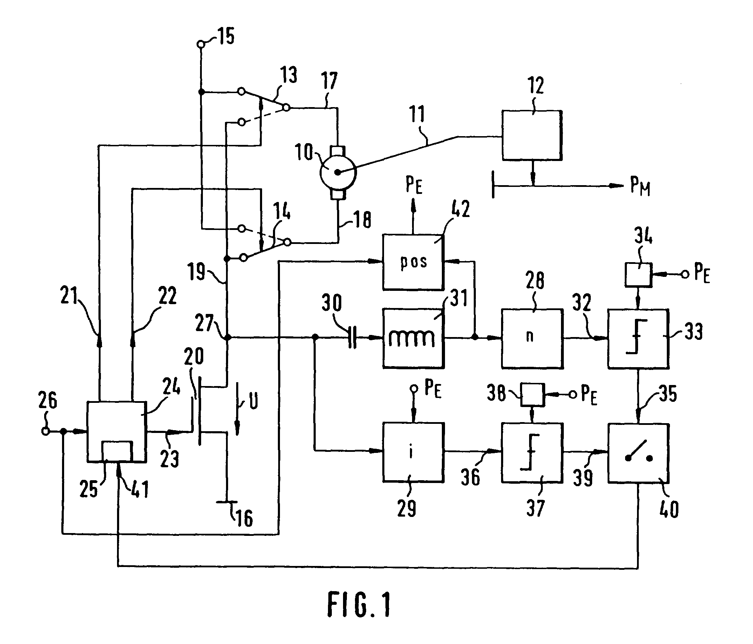

Ein Blockschaltbild einer erfindungsgemäßen Schaltungsanordnung zum Detektieren eines Überlastzustands in einem von einem Elektromotor angetriebenen Verstellantrieb ist in der einzigen Figur gezeigt.

Die Figur zeigt einen Elektromotor 10, der über eine mechanische Kopplung 11 ein zu verstellendes Teil 12 antreibt. Das zu verstellende Teil 12 kann unterschiedliche Positionen P_{M} einnehmen, die in der Figur durch die Positionsskale angedeutet sind. Der Elektromotor 10 ist über einen ersten und zweiten Umschalter 13, 14 mit einem ersten und zweiten Anschluß 15, 16 einer nicht näher gezeigten Energiequelle verbindbar. Der erste Umschalter 13 verbindet einen ersten Anschluß 17 des Elektromotors 10 entweder mit dem ersten oder dem zweiten Anschluß 15, 16. Der zweite Umschalter 14 verbindet einen zweiten Anschluß 18 des Elektromotors 10 ebenfalls entweder mit dem ersten oder zweiten Anschluß 15, 16. In einer von den Umschaltern 13, 14 zum zweiten Anschluß 16 führenden Leitung 19 ist ein Schaltelement 20 angeordnet, an dem ein Spannungsabfall U auftritt.

Sowohl die beiden Umschalter 13, 14 als auch das Schaltelement 20 werden von Steuersignalen 21, 22, 23 betätigt, die eine Steueranordnung 24 bereitstellt. In der Steueranordnung 24 ist eine Vorrangsschaltung 25 enthalten. Der Steueranordnung 24 wird ein Positioniersignal 26 zugeleitet.

Ein Abgriff 27 an der von den Umschaltern 13, 14 zum Schaltelement 20 führenden Leitung 19 ist sowohl mit einer Drehzahlermittlung 28 als auch mit einer Motorstromauswertung 29 verbunden. Zwischen Abgriff 27 und Drehzahlermittlung 28 sind in Reihe ein Kondensator 30 und eine Signalaufbereitung 31 geschaltet.

Die Drehzahlermittlung 28 gibt ein Ausgangssignal 32 an einen Drehzahlkomparator 33 ab, der das Ausgangssignal 32 mit einem Drehzahlgrenzwert 34 vergleicht und bei einer Grenzwertüberschreitung ein Freigabesignal 35 abgibt.

Die Motorstromauswertung 29 gibt als Ausgangssignal eine aus dem Motorstrom ermittelte Kenngröße 36 an einen Kenngrößenkomparator 37 ab, der die Kenngröße 36 mit einem Kenngrößengrenzwert 38 vergleicht und bei einer Grenzwertüberschreitung ein Schaltsignal 39 abgibt.

Eine Freigabe 40 leitet das Schaltsignal 39 als Überlastsignal 41 weiter, wenn gleichzeitig das Freigabesignal 35 anliegt. Das Überlastsignal 41 wird der Vorrangschaltung 25 zugeleitet.

Aus dem Ausgangssignal der Signalaufbereitung 31 wird in einer Positionsermittlung 42 die Position P_{M} des zu verstellenden Teils 12 ermittelt. Die Information über die Drehrichtung des Elektromotors 10 erhält die Positionsermittlung 42 aus dem Positioniersignal 26. Die Positionsermittlung 42 gibt als Maß für die Position P_{M} des zu verstellenden Teils 12 das Positionssignal P_{E} aus. Das Postionssignal P_{E} wird der Motorstromauswertung 29 zugeleitet und beeinflußt die Grenzwerte 34, 38.

Die erfindungsgemäße Schaltungsanordnung zum Detektieren eines Überlastzustands in einem vom Elektromotor 10 angetriebenen Verstellantrieb arbeitet folgendermaßen:

Der Elektromotor 10 und die mechanische Kopplung 11 sind Bestandteil eines Verstellantriebs 10, 11, 12, der vorgesehen ist, um das zu verstellende Teil 12 in unterschiedliche Positionen P_{M} zu bringen. Die mechanische Kopplung 11 entspricht beispielsweise einem Getriebe und einer Umsetzvorrichtung, die aus einer Drehbewegung eine hin- und hergehende Bewegung herstellt. Der Elektromotor 10 ist in beiden Drehrichtungen betreibbar. Die Vorgabe der beiden Drehrichtungen erfolgt über eine entsprechende Steuerung der beiden Umschalter 13, 14, die die beiden Anschlüsse 17, 18 des Elektromotors 10 mit den beiden Anschlüssen 15, 16 der nicht näher gezeigten Energiequelle jeweils verbinden.

Die Schaltstellungen der Umschalter 13, 14 werden von der Steueranordnung 24 in Abhängigkeit vom Positioniersignal 26 festgelegt und über die Steuersignale 21, 22 den beiden Umschaltern 13, 14 mitgeteilt. Das Positioniersignal 26 kann beispielsweise einen Auf-Zu-Befehl, einen Linksdrehung-Rechtsdrehung-Befehl oder einen Befehl über eine kontinuierliche Positionsvorgabe enthalten. Das in der Figur gezeigte Ausführungsbeispiel ist auf eine Steuerung abgestellt, bei der die Steueranordnung 24 keine Rückmeldung über die Position P_{M} des zu verstellenden Teils 12 zugeführt erhält. Die Erweiterung zu einer Positionsregelung ist durch eine Rückführung des Positionssignals P_{E} zur Steueranordnung 24 möglich.

Unter Zugrundelegung eines Gleichstrommotors und einer Gleichstromenergiequelle ergeben sich die beiden Drehrichtungen des Elektromotors 10 durch Umpolung über die Umschalter 13, 14. Ein Drehen des Elektromotors 10 in der einen Richtung wird erreicht durch Verbinden des ersten Motoranschlusses 17 über den ersten Umschalter 13 mit dem ersten Anschluß 15 der Energiequelle und Verbinden des zweiten Motoranschlusses 18 über den zweiten Umschalter 14 mit dem zweiten Anschluß 16 der Energiequelle. Bei einem Drehrichtungswechsel werden die Umschalter 13, 14 mittels der Steuersignale 21, 22 in die jeweils anderen Positionen umgeschaltet, so daß der erste Motoranschluß 17 über den ersten Umschalter 13 mit dem zweiten Anschluß 16 der Energiequelle und der zweite Motoranschluß 18 über den zweiten Umschalter 14 mit dem ersten Anschluß 15 der Energiequelle verbunden sind.

Ein Stillsetzen des Elektromotors 10 kann dadurch erreicht werden, daß beide Motoranschlüsse 17, 18 entweder mit dem ersten Anschluß 15 oder dem zweiten Anschluß 16 der Energiequelle verbunden werden. Der Elektromotor 10 ist dann jeweils kurzgeschlossen. Ein Abschalten des Elektromotors 10 ist weiterhin dadurch möglich, daß zumindest einer der beiden Umschalter 13, 14 einen weiteren Schaltkontakt aufweist, der weder zum ersten noch zum zweiten Anschluß 15, 16 der Energiequelle führt. Unabhängig von der Stellung der Umschalter 13, 14 kann der Elektromotor 10 über das Schaltelement 20 ein- und ausgeschaltet werden. Das Schaltelement 20 bietet daher eine weitere Möglichkeit, den Elektromotor 10 abzuschalten, unabhängig von der Stellung der Umschalter 13, 14. Das Schaltelement 20 wird vom Schaltsignal 23 betätigt, das die Steueranordnung 24 in Abhängigkeit vom Positioniersignal 26 festlegt.

Das Schaltelement 20 ist beispielsweise ein Halbleiter-Leistungsbauelement, vorzugsweise ein Transistor, der beispielsweise als MOSFET realisiert ist.

Ein Überlastzustand des den Elektromotor 10, die mechanische Kopplung 11 und das zu verstellende Teil 12 enthaltenden Verstellantriebs tritt beispielsweise bei einer Schwergängigkeit, einem Erreichen eines mechanischen Endanschlags oder durch ein Einklemmen von Gegenständen oder Körperteilen von Personen auf. Das Detektieren eines solchen Überlastungszustandes erfolgt durch Auswertung des durch den Elektromotor 10 fließenden Stromes. Der durch den Elektromotor 10 fließende Strom ist wenigstens näherungsweise ein Maß für das vom Elektromotor 10 bereitgestellte Drehmoment. Eine Erhöhung der Genauigkeit ist beispielsweise durch die Erfassung der Temperatur des Elektromotors 10 möglich, die zur Korrektur des Motorstroms herangezogen werden kann. Der durch den Elektromotor 10 fließende Strom ist deshalb gleichfalls ein Maß für die Verstellkraft oder das Verstelldrehmoment, mit der das zu verstellende Teil 12 bewegt wird.

Zur Erfassung des Motorstroms sind insbesondere Sensoren geeignet, die das den Strom begleitende Magnetfeld erfassen. Solche Sensoren sind beispielsweise Halleffektsensoren, magnetoresitive Elemente oder induktive Sensoren. Der Vorteil dieser Sensoren liegt darin, daß kein Eingriff in die stromführenden Leitungen erforderlich ist. Im Ausführungsbeispiel ist ein Stromsensor gezeigt, der eine den Motorstrom repräsentierende Signalspannung aufgrund eines an einem Widerstand auftretenden Spannungsabfalls bereitstellt. Ein solcher Sensor ist beispielsweise ein ohmscher Widerstand, der mit Blick auf den erwarteten hohen Motorstrom einen niedrigen Wert aufweisen sollte. Das Ausführungsbeispiel ist abgestellt auf die Erfassung des Spannungsabfalls U, der am Schaltelement 20 auftritt. Diese Stromerfassung weist den Vorteil auf, daß ein separater Sensor entfallen kann. Das Schaltelement 20 ist vorzugsweise ein Leistungs-MOSFET mit einem niedrigen Widerstand im Einschaltzustand. Der Zusammenhang zwischen dem Spannungsabfall U und dem durch den Feldeffekttransistor fließenden Strom ist für die vorgesehene Anwendung hinreichend linear. Gegebenenfalls kann eine elektronische Korrektur vorgenommen werden.

Der Spannungsabfall U wird am Abgriff 27 von der Leitung 19 ausgekoppelt und sowohl der Motorstromauswertung 29 als auch der Drehzahlermittlung 28 zugeleitet.

Die Motorstromauswertung 29 ermittelt eine Kenngröße des Motorstroms, wobei beispielsweise die absolute Höhe des Motorstroms und/oder die zeitliche Änderung des Motorstroms und/oder die ortsbezogene Änderung des Motorstroms berücksichtigt werden können. Gegebenenfalls kann eine Addition von der absoluten Motorstromhöhe mit einem der ermittelten Änderungswerte vorgesehen sein. Bei der Ermittlung der Änderungen können sowohl die erste als auch höhere Ableitungen entweder nach der Zeit oder nach dem Ort berücksichtigt werden.

Die in der Motorstromauswertung 29 ermittelte Kenngröße 36 wird im Kenngrößenkomparator 37 mit dem Kenngrößengrenzwert 38 verglichen. Der Kenngrößengrenzwert 38 kann beispielsweise eine fest vorgegebene Zahl sein. Vorzugsweise hängt der Kenngrößengrenzwert 38 von der elektrischen Spannung der in der Figur nicht gezeigten Energiequelle ab, mit der der Elektromotor 10 über die beiden Anschlüsse 15, 16 verbindbar ist. Weiterhin hängt der Kenngrößengrenzwert 38 vorzugsweise von der Position P_{M} des zu verstellenden Teils 12 ab. Die Beeinflussung erfolgt über das Positionssignal P_{E}. Mit dieser Maßnahme werden Positionen P_{M} oder Positionsbereiche des zu verstellenden Teils 12, die gegebenenfalls eine erhöhte Stellkraft erfordern, bei der Festlegung des Kenngrößengrenzwerts 38 berücksichtigt. Bei einer Schwellenuberschreitung im Sinne einer Überschreitung des Kenngrößengrenzwerts 38 durch die Kenngröße 36 gibt der Kenngrößenkomparator 37 das Schaltsignal 39 an die Freigabe 40 ab.

In einer realisierten Schaltungsanordnung kann ein umfangreicher Auswertealgorithmus zur Ermittlung eines Überlastzustands oder eines Einklemmens vorgesehen sein. In diesem Sinne ist der beschriebene Vergleich der Kenngröße 36 mit dem Grenzwert 38 als sehr einfaches Ausführungsbeispiel zu sehen, um ein Überlastsignal 41 zu erhalten.

Die Drehzahlermittlung 28 ermittelt eine Drehzahl des Verstellantriebs 10, 11, 12 im gezeigten Ausführungsbeispiel aus der Welligkeit des Motorstroms. Die Welligkeit im Motorstrom ist durch Kommutierungsvorgänge im Elektromotor 10 verursacht und hängt demzufolge vom Aufbau des Elektromotors 10 ab. Die Anzahl der Wellen während einer Umdrehung des Elektromotors 10 ist konstruktionsbedingt festgelegt.

Eine Auswertung der Welligkeit des Motorstroms ermöglicht daher nicht nur die Ermittlung zumindest eines Maßes für die Drehzahl des Elektromotors 10, sondern gestattet gleichermaßen die Ermittlung der Position P_{M} des zu verstellenden Teils 12 mit einem inkrementellen Verfahren. Die Anzahl der einzelnen Wellen zählt ein in der Positionsermittlung 42 enthaltener Vorwärts-Rückwärts-Zähler. Die Information über die Antriebsrichtung erhält die Positionsermittlung 42 über das Positioniersignal 26. Eine Kalibrierung in der Positionsermittlung 42 kann durch eine in der Figur nicht näher gezeigte Bezugsmarke erfolgen, die innerhalb des Verstellantriebs 10, 11, 12 oder am zu verstellenden Teil 12 angeordnet ist. Eine weitere Kalibriermöglichkeit ist gegeben durch das Anfahren einer vorgegebenen Position P_{M} und ein entsprechendes Setzen des in der Positionsermittlung 42 vorhandenen Zählers. Beispielsweise kann das zu verstellende Teil 12 an einen mechanischen Endanschlag gefahren werden, dessen Erreichen durch das Auftreten des Schaltsignals 39 angezeigt wird. Mit dem Schaltsignal 39 kann der in der Positionsermittlung 42 enthaltene Zähler beispielsweise auf den Zählerstand Null gesetzt werden.

Die Auswertung der Welligkeit des Motorstroms wird vorbereitet in der Signalaufbereitung 31. Der in Signalflußrichtung vor der Signalaufbereitung 31 eingetragene Kondensator 30 bringt zum Ausdruck, daß von dem am Abgriff 27 auftretenden Spannungsabfall U lediglich die Wechselanteile benötigt werden. Die Signalaufbereitung 31 enthält beispielsweise eine Verstärkerschaltung und vorzugsweise Signalfilterschaltungen, welche die Welligkeit des Motorstroms von überlagerten höherfrequenten und niederfrequenteren Signalanteilen befreien. Die Signalaufbereitung 31 enthält ausgangsseitig vorzugsweise eine Signalumformung, die aus den sinusbogenähnlichen Signalanteilen des Motorstroms ein rechteckförmiges Signal bereitstellt, welches unmittelbar als Schaltsignal für den in der Positionsermittlung 42 vorhandenen Zähler verwendbar ist. Das rechteckförmige Signal kann gleichermaßen einfach in der Drehzahlermittlung 28 durch eine Zeitermittlung zwischen Pegelwechseln ausgewertet und in das Ausgangssignal 32 umgewandelt werden, das ein Maß für eine im Verstellantrieb 10, 11, 12 auftretende Drehzahl ist. Das Ausgangssignal 32 ist gleichfalls als ein Maß für die Geschwindigkeit des zu verstellenden Teils 12 oder eines anderen Teils innerhalb des Verstellantriebs 10, 11, 12. Die drehzahlbezogenen Werte sind deshalb auch als geschwindigkeitsbezogene Werte zu sehen. Das Ausgangssignal 32 wird im Drehzahlkomparator 33 mit dem Drehzahlgrenzwert 34 verglichen. Entsprechend dem Kenngrößengrenzwert 38 kann der Drehzahlgrenzwert 34 eine fest vorgegebene Zahl oder vorzugsweise ein Wert sein, der von anderen Größen abhängt. Neben der Abhängigkeit von der Betriebsspannung ist vorzugsweise eine Abhängigkeit von der Position P_{M} des zu verstellenden Teils 12 über das Positionssignal P_{E} vorgesehen. Bei einer Grenzwertüberschreitung im Sinne einer Unterschreitung gibt der Drehzahlkomparator 33 das Freigabesignal 35 ab.

Das Auftreten des Freigabesignals 35 ist Voraussetzung für das in der Freigabe 40 vorgesehene Durchschalten des Schaltsignals 39, das bei vorhandenem Freigabesignal 35 als Überlastsignal 41 ausgegeben wird.

Das Überlastsignal 41 kann auf unterschiedliche Weise verwendet werden. Neben einem optischen und/oder akustischen Alarm ist vorzugsweise ein Abschalten des Elektromotors 10 vorgesehen. Eine andere Maßnahme, die beispielsweise in Abhängigkeit von der Position P_{M} des zu verstellenden Teils 12 vorgesehen sein kann, sieht die Reversierung der Drehrichtung des Elektromotors 10 vor. Mit dem Reversieren, das auf eine vorgegebene Zeit oder auf einen vorgegebenen Verstellweg begrenzt sein kann, werden beispielsweise eingeklemmte Gegenstände oder Körperteile von Personen freigegeben. Das Überlastsignal 41 ist zu diesem Zweck der im Ausführungsbeispiel gezeigten Vorrangsschaltung 25 zugeleitet, die unmittelbar in die Steueranordnung 24 vorrangig eingreift. Der Vorrang ist darin zu sehen, daß die Steuersignale 21, 22, 23 von der Vorrangsschaltung 25 und nicht mehr vom Positioniersignal 26 festgelegt werden.

## Patentansprüche

1. Schaltungsanordnung zum Detekieren eines Überlastzustands in einem von einem Elektromotor angetriebenen Verstellantrieb, mit einer Motorstromauswertung, die wenigstens eine Kenngröße des Motorstroms ermittelt, mit einem Kenngrößenkomparator, der die ermittelte Kenngröße mit wenigstens einem Kenngrößengrenzwert vergleicht und in Abhängigkeit von einer Grenzwertüberschreitung ein Schaltsignal abgibt, mit einer Drehzahlermittlung (28), die ein Maß (32) für eine Drehzahl oder eine Geschwindigkeit im Verstellantrieb (10, 11, 12) bereitstellt, mit einem Drehlzahlkomparator (33), der das Maß (32) mit einem Drehzahlgrenzwert (34) vergleicht und bei einer Grenzwertunterschreitung ein Freigabesignal (35) abgibt, dadurch gekennzeichnet, daß eine Freigabe (40) vorgesehen ist, die nur bei einem Auftreten des Freigabesignals (35) das Schaltsignal (39) als Überlastsignal (41) ausgibt.

2. Schaltungsanordnung nach Anspruch 1, dadurch gekennzeichnet, daß bei der Kenngröße (36) des Motorstroms der Betrag des Motorstroms berücksichtigt ist.

3. Schaltungsanordnung nach Anspruch 1, dadurch gekennzeichnet, daß bei der Kenngröße (36) des Motorstroms eine zeitliche Änderung des Motorstroms berücksichtigt ist.

4. Schaltungsanordnung nach Anspruch 1, dadurch gekennzeichnet, daß bei der Kenngröße (36) des Motorstroms eine ortsbezogene Motorstromänderung berücksichtigt ist.

5. Schaltungsanordnung nach Anspruch 2 sowie 3 oder 4, dadurch gekennzeichnet, daß bei der Ermittlung der Kenngröße (36) die absolute Höhe des Motorstroms sowie eine Motorstromänderung berücksichtigt sind.

6. Schaltungsanordnung nach Anspruch 1, dadurch gekennzeichnet, daß die Drehzahl oder die Geschwindigkeit im Verstellantrieb (10, 11, 12) aus der Welligkeit des durch den Elektromotor (10) fließenden Stroms abgeleitet ist.

7. Schaltungsanordnung nach Anspruch 1, dadurch gekennzeichnet, daß der durch den Elektromotor (10) fließende Strom über einen Spannungsabfall (U) an einem Transistor (20) erfaßt wird.

8. Schaltungsanordnung nach Anspruch 1, dadurch gekennzeichnet, daß wenigstens ein Grenzwert (34, 38) von der Position (P_{M}) eines zu verstellenden Teils (12) abhängt.

9. Schaltungsanordnung nach Anspruch 8, dadurch gekennzeichnet, daß eine inkrementelle Positionsermittlung (42) aus der Welligkeit des durch den Elektromotor (10) fließenden Stroms vorgesehen ist.

10. Verwendung der Schaltungsanordnung nach Anspruch 1 bei einer Verstellvorrichtung (10, 11, 12) in einem Kraftfahrzeug.

## Claims

1. Circuit arrangement for detecting an overload state in an actuator driven by an electric motor, having a motor current evaluation unit which determines at least one parameter of the motor current, having a parameter comparator which compares the parameter determined with at least one parameter limiting value and emits a switching signal as a function of overshooting of the limiting value, having a rotational speed detecting unit (28) which provides a measure (32) of a rotational speed or a speed in the actuator (10, 11, 12), and having a rotational speed comparator (33) which compares the measure (32) with a rotational speed limiting value (34) and emits an enabling signal (35) in the case of undershooting of the limiting value, characterized in that an enabling unit (40) is provided which outputs the switching signal (39) as overload signal (41) only upon an occurrence of the enabling signal (35).

2. Circuit arrangement according to Claim 1, characterized in that the absolute value of the motor current is taken into account in the case of the parameter (36) of the motor current.

3. Circuit arrangement according to Claim 1, characterized in that a temporal change in the motor current is taken into account in the case of the parameter (36) of the motor current.

4. Circuit arrangement according to Claim 1, characterized in that a spatially referred change in motor current is taken into account in the case of the parameter (36) of the motor current.

5. Circuit arrangement according to Claim 2 and 3 or 4, characterized in that the absolute level of the motor current and a change in motor current are taken into account when determining the parameter (36).

6. Circuit arrangement according to Claim 1, characterized in that the rotational speed or the speed in the actuator (10, 11, 12) is derived from the ripple in the current flowing through the electric motor (10).

7. Circuit arrangement according to Claim 1, characterized in that the current flowing through the electric motor (10) is detected via a voltage drop (U) across a transistor (20).

8. Circuit arrangement according to Claim 1, characterized in that at least one limiting value (34, 38) depends on the position (P_{M}) of a part (12) to be adjusted.

9. Circuit arrangement according to Claim 8, characterized by the provision of an incremental determination of position (42) from the ripple of the current flowing through the electric motor (10).

10. Use of the circuit arrangement according to Claim 1 in an actuator (10, 11, 12) in a motor vehicle.

## Revendications

1. Circuit servant à détecter un état de surcharge dans un mécanisme d'entraînement de réglage, entraîné par un moteur électrique, circuit qui comprend un appareil d'exploitation de l'intensité du moteur qui détermine au moins une grandeur caractéristique de l'intensité du moteur, un comparateur de grandeurs caractéristiques qui compare la grandeur caractéristique déterminée avec au moins une valeur limite de grandeur caractéristique et délivre un signal de commande en fonction d'un dépassement d'une valeur limite, un appareil qui détermine la vitesse de rotation (28), et qui fournit une mesure (32) d'une vitesse de rotation ou d'une vitesse dans le mécanisme d'entraînement de réglage (10, 11, 12), un comparateur de vitesse de rotation (33) qui compare la mesure (32) à une valeur limite (34) de vitesse de rotation et délivre en cas de sous-dépassement de la valeur limite un signal de libération (35),
caractérisé en ce que
l'on prévoit un appareil de libération (40) qui délivre le signal de commande (39) en tant que signal de surcharge (41) seulement quand survient le signal de libération (35).

2. Circuit selon la revendication 1,
caractérisé en ce que
l'on prend en considération dans le cas de la grandeur caractéristique (36) de l'intensité du moteur, le montant de l'intensité du moteur.

3. Circuit selon la revendication 1,
caractérisé en ce que
dans le cas de la grandeur caractéristique (36) de l'intensité du moteur on prend en considération une variation dans le temps de l'intensité du moteur.

4. Circuit selon la revendication 1,
caractérisé en ce que
dans le cas de la grandeur caractéristique (36) de l'intensité du moteur on prend en considération une variation de l'intensité du moteur en fonction de l'endroit.

5. Circuit selon la revendication 1 et 3 ou 4,
caractérisé en ce que
lors de la détermination de la grandeur caractéristique (36) on prend en considération l'amplitude absolue de l'intensité du moteur et une variation de l'intensité du moteur.

6. Circuit selon la revendication 1,
caractérisé en ce que
l'on prélève la vitesse de rotation ou la vitesse dans le mécanisme d'entraînement de réglage (10, 11, 12) à partir de l'ondulation de l'intensité qui passe à travers le moteur électrique (10).

7. Circuit selon la revendication 1,
caractérisé en ce que
l'intensité qui passe à travers le moteur électrique (10) est détectée au moyen d'une chute de tension (U) sur un transistor (20).

8. Circuit selon la revendication 1,
caractérisé en ce que
au moins une valeur limite (34, 38) dépend de la position (P_{M}) d'une pièce à régler (12).

9. Circuit selon la revendication 8,
caractérisé en ce que
l'on prévoit une détermination incrémentielle (42) de l'ondulation de l'intensité qui passe à travers le moteur électrique (10).

10. Utilisation du circuit selon la revendication 1 dans le cas d'un dispositif de réglage (10, 11, 12) dans un véhicule à moteur.
